# EUROPEAN PATENT SPECIFICATION

(11) **EP 0 984 456 B1**
(45) Date of publication and mention of the grant of the patent: **04.06.2003**
(21) Application number: 99116778.4
(22) Date of filing: 31.08.1999
(51) Int. Cl.: G11C 16/20, G11C 5/00

(54) **Semiconductor integrated circuit with product specification altering function**
Halbleiterschaltung mit Produktspezifikationsänderungsfunktion
Circuit integré semiconducteur avec fonction de changement de spécification de produit

(30) Priority: 02.09.1998 JP 24854998
(43) Date of publication of application: 08.03.2000
(73) Proprietor: NEC Electronics Corporation, Kawasaki, Kanagawa 211-8668 (JP)
(72) Inventor: Shouki, Teruichi, NEC IC Microcomputer Systems Ltd, Kawasaki-shi, Kanagawa (JP)
(74) Representative: VOSSIUS & PARTNER

(56) References cited:
- WO-A-98/29890
- US-A- 5 539 692
- US-A- 5 633 827
- US-A- 5 678 082

## Description

The present invention relates to a semiconductor large-scale integrated circuit (LSI), and particularly to a semiconductor integrated circuit for which product specifications can be re-set and to the method of setting product specifications.

The increasing complexity of electrical products in recent years has created a demand for semiconductor integrated circuits having a wide variety of specifications. Producing LSI chips that meet the specifications demanded by users in a short time and quickly providing these products to users has become a key issue in the semiconductor device industry.

To solve this type of problem, JP-A-3-50850 discloses a semiconductor device incorporating a plurality of fuse elements that allow selective connection of circuits such as pull-up resistance to input/output terminals by programmably fusing (blowing) these fuse elements in order to match the input/output characteristics of a semiconductor device to the various users' demands. In the semiconductor device described in JP-A-3-050850, an MPU (microprocessor unit) stores in a register the commands or data read from a main storage device such as ROM, carries out code processing by a command decoder, and generates control signals for programmably fusing the fuse elements. The commands used in fusing fuses are blank commands that have no direct communication with the control and computation unit of the MPU. In this way, a noise canceling circuit, pull-up resistance, or pull-down resistance that is built in beforehand can be cut off from the input/output terminals by selective fusing of fuse elements, thereby allowing connection of only the necessary circuit elements to the input/output terminals. However, since fuse elements that have once been cut off cannot be reconnected in the semiconductor device described in JP-A-3-050850, the semiconductor integrated circuit cannot be subsequently put to a different use by altering the specifications of the semiconductor integrated circuit.

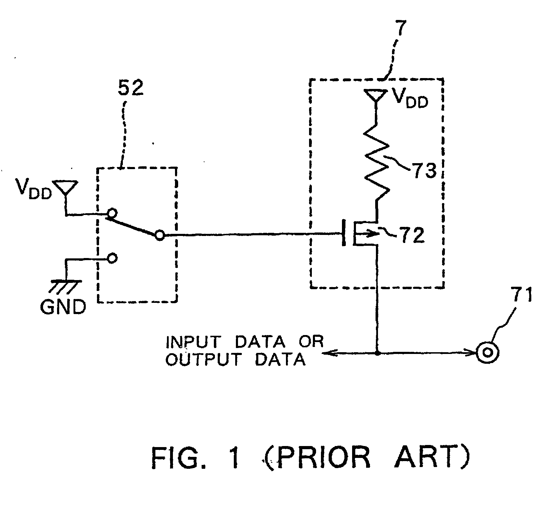

In a semiconductor integrated circuit that incorporates a mask ROM (read only memory) and microprocessor, the program, which is software for the microprocessor, is stored in the mask ROM by the aluminum wiring process at the time of fabricating the semiconductor integrated circuit. The ON/OFF of pull-up. resistance circuits with respect to the LSI terminals, which are the external terminals of the semiconductor integrated circuit, can be matched to users' demands through this aluminum wiring process, and this type of setting has been carried out in the prior art as a "mask option". Fig. 1 is an explanatory view of the ON/OFF setting of a pull-up resistance circuit by the mask option.

Pull-up resistance circuit 7 is made up of a p-channel MOS (metal-oxide-semiconductor) transistor 72 having its drain connected to LSI terminal 71, and resistor 73 having one end connected to the V_{DD} level and the other end connected to the source of p-channel MOS transistor 72. The gate of p-channel MOS transistor 72 is connected by aluminum wiring 52 to either the V_{DD} level or the ground (GND) level. Aluminum wiring 52 is formed by the aluminum wiring process at the time of fabricating the mask ROM. When the gate of p-channel MOS transistor 72 is connected to the V_{DD} level by aluminum wiring 52, pull-up resistance 73 is cut off from LIS terminal 71. On the other hand, when the gate is connected to the GND level, pull-up resistance 73 is connected to LSI terminal 71.

This semiconductor integrated circuit has the advantage that time is saved during fabrication because functions are selected by means of the mask used in the aluminum wiring process. However, the method of setting product specifications by means of the mask option precludes the selection of other functions once product specifications have been set.

JP-A-2-176883/90 discloses a single-chip microcomputer that allows arbitrary construction of the logic functions of a logic device to meet the specifications demanded by various users. The logical devices incorporated in this single-chip microcomputer are provided with a control circuit that includes an electrically programmable nonvolatile memory element, an arithmetic circuit, and a plurality of pairs of address registers and status registers. This microcomputer is configured such that the control circuit can arbitrarily select one pair from among the plurality of address register and status register pairs in response to information written to the nonvolatile semiconductor memory.

Further, semiconductor integrated circuits that meet the demands of various users through the provision of nonvolatile memory within the semiconductor integrated circuit that is dedicated to storing product specifications are disclosed in, for example, JP-A-1-162971 and JP-A-2-176883. In these semiconductor integrated circuits, a nonvolatile memory element is provided exclusively for storing product specifications within the control circuit at locations other than areas for normal program storage, and control for setting specifications is carried out within the control circuit through the execution of dedicated commands. These semiconductor integrated circuits thus increase the versatility of a single-chip microcomputer which can be matched to the desired specifications of each individual user, and offer the advantage of allowing a reduction in the number of components that constitute the peripheral circuits of a single-chip microprocessor. Nevertheless, the provision of nonvolatile memory within each control circuit gives rise to the problem of increased layout area for control circuits and other components for controlling these nonvolatile memories.

In conclusion, the above-described semiconductor integrated circuits of the prior art have the following problems:
(1) The method of setting product specifications by means of fuse elements and mask option does not allow alteration to other specifications after setting.
(2) The method of providing dedicated nonvolatile memory to, for example, control circuits, and storing product specification information in this nonvolatile memory results in a considerable increase in the layout area of the semiconductor integrated circuit.

WO 98/29890 discloses an interface for flash EEPROM memory arrays. The circuit receives respective commands corresponding to the plurality of memory devices, each having different characteristics, and then supplies data, which is to be set, to a query memory.

It is an object of the present invention to provide a semiconductor integrated circuit that allows alteration of settings after product specifications have once been set without entailing a large increase in layout area.

It is another object of the present invention to provide a method of setting product specifications of a semiconductor integrated circuit that allows alteration of settings after product specifications have once been set without entailing a large increase in layout area.

These objects are achieved with the features of the claims.

The semiconductor integrated circuit of this invention includes a nonvolatile memory such as EEPROM (electrically erasable programmable read only memory) or flash ROM, which is an electrically programmable and erasable memory. A product specification setting region which is used for storing product specification setting information is provided within the nonvolatile memory in addition to a program region for storing programs that are to be executed by this semiconductor integrated circuit, and product specification setting information is outputted from the nonvolatile memory as a product specification selecting signal. Product specifications of a semiconductor integrated circuit are set and controlled using product specification selecting signals.

The semiconductor integrated circuit of this invention thus can satisfy a plurality of user-requested specifications with one semiconductor integrated circuit without greatly expanding the layout area, and in addition, allows settings to be altered even after product specifications have once been set. Preferably, the semiconductor integrated circuit of this invention is further provided with a decoder for decoding product specification selecting signals and for generating product specification signals for controlling product specifications.

The above and other objects, features, and advantages of the present invention will become apparent from the following description based on the accompanying drawings which illustrate examples of the present invention.
Fig. 1 is a circuit diagram for explaining the setting of a pull-up resistance by a mask option;
Fig. 2 is a block diagram showing the configuration of a semiconductor integrated circuit according to the first embodiment of the present invention;
Fig. 3 is a block diagram for explaining the setting of a pull-up resistance in the semiconductor integrated circuit shown in Fig. 2;
Fig. 4 is a flow chart showing the processing when setting to connect a pull-up resistance in the semiconductor integrated circuit shown in Fig. 3;
Fig. 5 is a flow chart showing the processing when setting to cut off a pull-up resistance in the semiconductor integrated circuit shown in Fig. 3;
Fig. 6 is a block diagram showing the configuration of a semiconductor integrated circuit according to the second embodiment of the present invention; and
Fig. 7 is a block diagram showing the configuration of a semiconductor integrated circuit according to the third embodiment of the present invention.

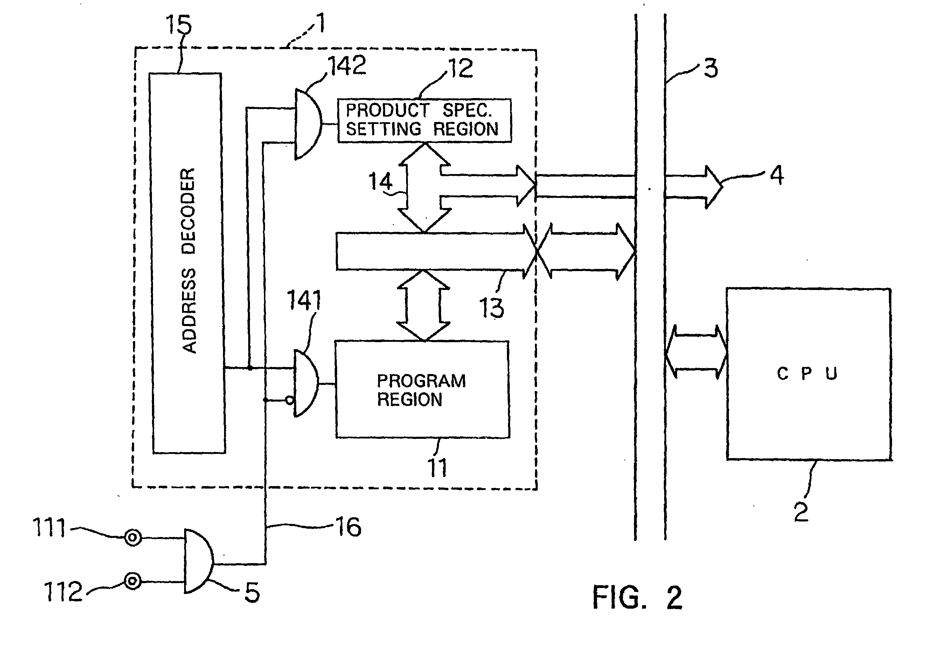

The semiconductor integrated circuit according to the first embodiment of the present invention shown in Fig. 2 incorporates nonvolatile memory 1 and CPU (Central Processing Unit) 2, nonvolatile memory 1 and CPU 2 being connected by internal bus 3. Nonvolatile memory 1 may be EEPROM (Electrically Erasable and Programmable ROM) or flash ROM.

Nonvolatile memory 1 is comprising: program region 11 for storing programs that are executed by CPU 2, product specification setting region 12 for storing product specification setting information, address decoder 15, AND circuits 141 and 142, and data bus 13 connected to internal bus 3. Program region 11 and product specification setting region 12 are both structures for reading and writing data via data bus 13. As will be explained hereinbelow, AND circuits 141 and 142 function as selection circuits for selecting one of program region 11 and product specification setting region 12.

The addresses of product specification setting region 12 are mapped to the same address spaces of program region 11. Programs executed by this CPU 2 are stored in advance to program region 11.

AND circuit 5 has as inputs LSI terminal 111 and IC (Internally Connected) terminal 112 provided as the external terminals of this semiconductor integrated circuit, calculates the logical product of the signals at LSI terminal 111 and IC terminal 112, and outputs this result as product specification setting region enable signal 16 for distinguishing program region 11 and product specification setting region 12 within nonvolatile memory 1.

In this case, it is assumed that a high-level signal is applied to IC terminal 112 when the product specification are to be altered, and a high-level or low-level signal is applied to LSI terminal 111 when a high-level signal is applied to IC terminal 112, thereby enabling selection of which of program region 11 and product specification setting region 12 may be accessed. Here, a signal in a high-level state means that the signal is in an activated state.

Address decoder 15 makes its output signal high-level when address signals (not shown) that are applied to nonvolatile memory 1 match a preset address.

AND circuit 141 activates its output signal when the output signal from address decoder 15 is active and product specification setting region enable signal 16 is inactive, and AND circuit 142 activates its output signal when the output signal from address decoder 15 and product specification setting region enable signal 16 are both active.

Product specification setting region 12 can be accessed when the output signal of AND circuit 142 becomes high-level, that is, activated, and program region 11 can be accessed when the output signal of AND circuit 141 becomes high level.

In the interest of simplifying the explanation in Fig. 2, product specification setting region 12 and program region 11 are configured such that, according to output signals from AND circuits 141 and 142, only the regions corresponding to one address can be accessed, but in actuality, product specification setting region 12 and program region 11 are configured such that regions corresponding to a plurality of addresses of program region 11 and product specification setting region 12 are accessed through the output of signals from address decoder 15 corresponding to a plurality of addresses and the provision of a plurality of AND circuits 141 and 142.

In addition, bit data 14 outputted from product specification setting region 12 to data bus 13 is also supplied outside nonvolatile memory 1 as product specification selecting signal 4 without passing by way of data bus 13. Product specification selecting signal 4 is product specification setting information stored in product specification setting region 12 that is outputted as a signal, and is a signal for determining the product specifications of the semiconductor integrated circuit.

In this semiconductor integrated circuit, the logic of product specification selecting signal 4 outputted from nonvolatile memory 1 is controlled by the value written to product specification setting region 12 provided within nonvolatile memory 1, and a single semiconductor integrated circuit therefore can satisfy the specifications demanded by a plurality of users. In this way, a semiconductor integrated circuit provided with functions demanded by a user can be quickly provided to the user.

In addition, the ability to easily alter the product specification settings allows evaluation of the plurality of functions in one semiconductor integrated circuit, thereby enabling shorter development time and lower development costs.

If the method of setting product specifications is disclosed to the user, the user himself of herself can then select the desired functions and apply the same LSI chip to a plurality of uses.

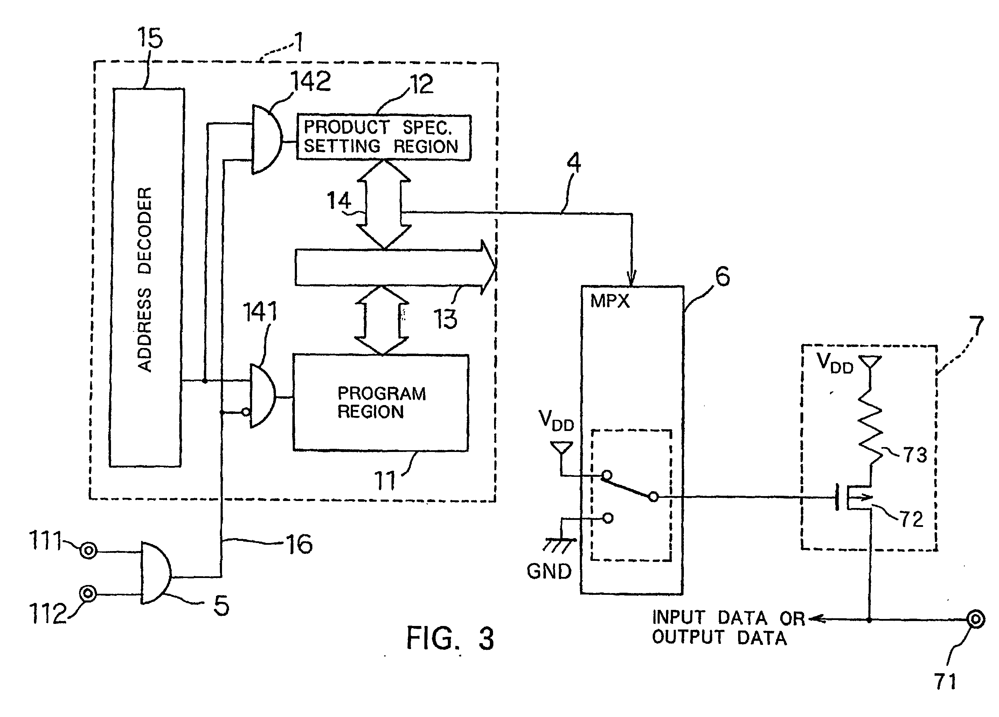

Fig. 3 shows a concrete example of the configuration of the semiconductor integrated circuit shown in Fig. 2. In this case, explanation is presented regarding a configuration for using product specification selecting signal 4 outputted from product specification setting region 12 of nonvolatile memory 1 to realize the ON/OFF control of a pull-up resistance. The semiconductor integrated circuit described in this case is an example in which multiplexer (MPX) 6 and pull-up resistance circuit 7 are connected to the semiconductor integrated circuit shown in Fig. 2. In the interest of simplifying the explanation, the depiction of CPU 2 and internal bus 3 is omitted in Fig. 3.

Pull-up resistance circuit 7 is made up of p-channel MOS transistor 72 having its drain connected to LSI terminal 71, which is the external terminal of the semiconductor integrated circuit; and resistor 73 having one end connected to the V_{DD} level and the other end connected to the source of p-channel MOS transistor 72. Multiplexer 6 receives product specification selecting signal 4 as input, and based on product specification selecting signal 4, connects the gate of p-channel MOS transistor 72 within pull-up resistance circuit 7 to the V_{DD} level or the GND level. Multiplexer 6 effects ON/OFF setting of the pull-up resistance at LSI terminal 71 by connecting the gate of MOS transistor 72 to the V_{DD} level or the GND level.

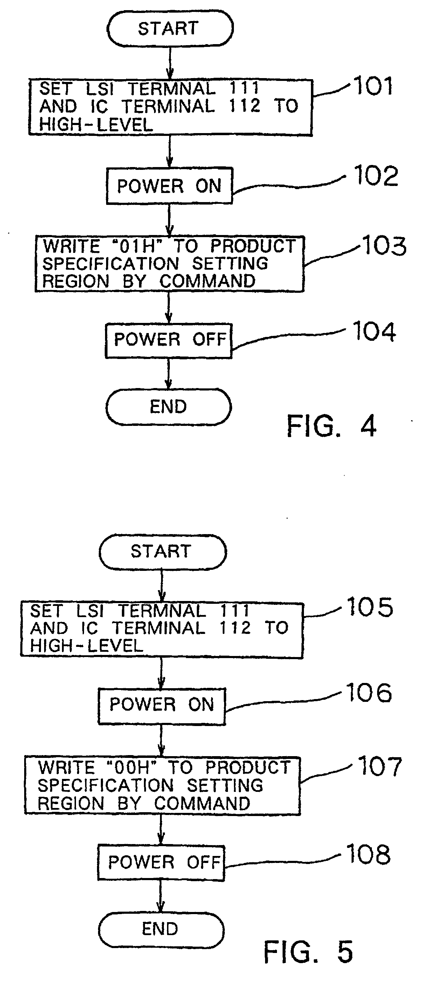

Explanation is next presented regarding the ON/OFF setting of the pull-up resistance in this semiconductor integrated circuit using Figs. 4 and 5. Fig. 4 shows operations when connecting pull-up resistance to the LSI terminal, and Fig. 5 shows operations when cutting off the pull-up resistance from the LSI terminal. In the following explanation, "H" indicates hexadecimal notation.

As shown in Fig. 4, when the pull-up resistance is to be connected to LSI terminal 71, settings are first effected in Step 101 outside semiconductor integrated circuit (LSI chip) such that LSI terminal 111 and IC terminal 112 become high level in order to activate product specification setting region 12 when the power supply is turned on. The power supply is turned on in Step 102, and "01H" is written to product specification setting region 12 by a command in Step 103, whereby product specification selecting signal 4 becomes high level and multiplexer 6 connects the gate of MOS transistor 72 to the GND level. MOS transistor 72 thus turns ON to result in a state in which the pull-up resistance is connected to LSI terminal 71. Finally, the power supply is cut off in Step 104 and processing is completed.

When cutting the pull-up resistance off from LSI terminal 71 as shown in Fig. 5, settings are similarly first made outside the LSI chip in Step 105 such that LSI terminal 111 and IC terminal 112 become high level, whereby product specification setting region 12 becomes active when the power supply is introduced. Then, the power supply is turned on in Step 106, and "00H" is written to product specification setting region 12 by command in Step 107. Product specification selecting signal 4 thus becomes low level, and multiplexer 6 connects the gate of MOS transistor 72 to the V_{DD} level. MOS transistor 72 therefore enters an OFF state to produce a state in which LSI terminal 71 is cut off from the pull-up resistance. The power supply is finally cut off in Step 108 and processing is completed.

Writing values to product specification setting region 12 thus controls the logic of product specification selecting signal 4 outputted from nonvolatile memory 1 to enable alteration of the connected function of the pull-up resistance. As a result, a single semiconductor integrated circuit can satisfy a plurality of user-demanded specifications.

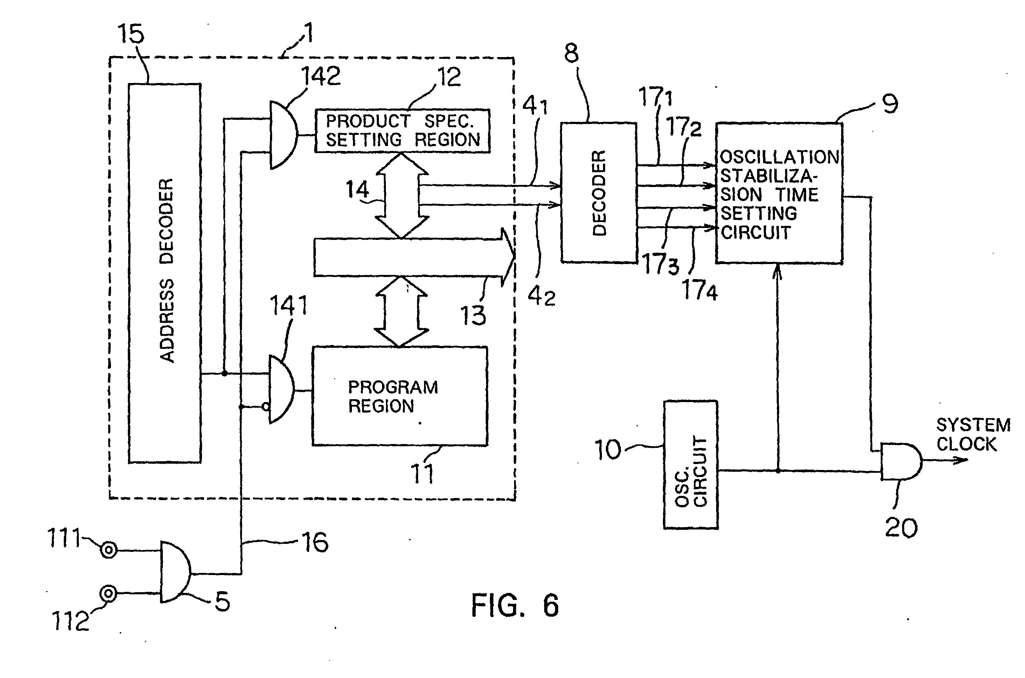

Specification setting in the present invention is not limited solely to the presence or absence of a pull-up resistance. The semiconductor integrated circuit according to the second embodiment of the present invention shown in Fig. 6 incorporates oscillation stabilization time setting circuit 9 for crystal oscillation circuit 10 that generates a system clock. Here, setting the length of the oscillation stabilization time interval is treated as a product specification. In a case in which the crystal oscillator of oscillation circuit 10 is installed outside the semiconductor integrated circuit, the oscillation stabilization time interval refers to the time up to stabilization of oscillation of the crystal oscillator during which the operation of the semiconductor integrated circuit is halted. Although neither CPU 2 nor internal bus 3 are depicted in Fig. 6, the semiconductor integrated circuit of the second embodiment is provided with a CPU and internal bus similar to the semiconductor integrated circuit shown in Fig. 2.

In the semiconductor integrated circuit shown in Fig. 6, product specification selecting signals 4₁ and 4₂ are outputted from product specification setting region 12 within nonvolatile memory 1. Product specification selecting signals 4₁ and 4₂ are decoded in decoder 8 to product specification signals 17₁-17₄. Table 1 below shows the relation between input and output in decoder 8.

**TABLE 1**

| Product specification selecting signal 4₁ | Product specification selecting signal 4₂ | Product specification signal 17₁ | Product specification signal 17₂ | Product specification signal 17₃ | Product specification signal 17₄ |
|---|---|---|---|---|---|
| 0 | 0 | 0 | 0 | 0 | 1 |
| 0 | 1 | 0 | 0 | 1 | 0 |
| 1 | 0 | 0 | 1 | 0 | 0 |
| 1 | 1 | 1 | 0 | 0 | 0 |

As shown in Table 1, decoder 8 activates one of. product specification signals 17₁-17₄ according to the combination of two signals, i.e., product specification selecting signals 4₁ and 4₂.

Oscillation stabilization time setting circuit 9 guarantees an oscillation stabilizing time period by effecting control such that signals outputted to AND circuit 20 are activated after the passage of a set time interval from the time oscillation circuit 10 begins oscillating and the output of oscillation circuit 10 is outputted as a system clock. Oscillation stabilization time setting circuit 9 changes the oscillation stabilization time period according to which product specification signals 17₁-17₄ become active. Accordingly, this semiconductor integrated circuit can set the oscillation stabilization time period to conform with the user-requested specifications.

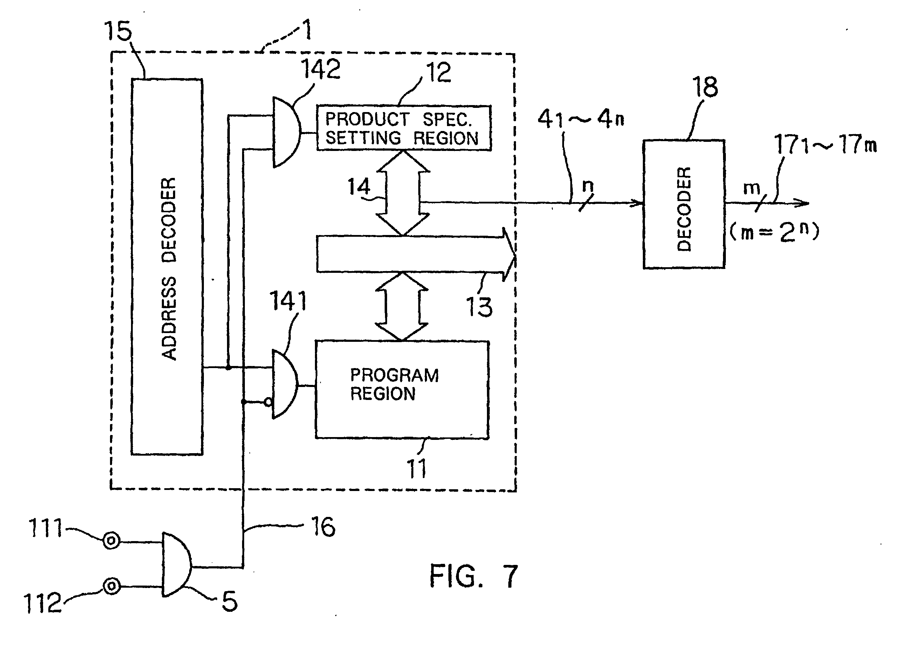

Although the logic of four types of product specification signals 17₁-17₄ is controlled by applying two product specification selecting signals 4₁ and 4₂ to decoder 8 in the semiconductor integrated circuit shown in Fig. 6, the present invention can effect control using still more product specification signals. In the semiconductor integrated circuit according to the third embodiment of the present invention shown in Fig. 7, *m* (*m*=2^{*n*}) product specification signals 17₁-17_{*m*} are controlled by outputting *n* (*n*>2) product specification selecting signals 4₁-4ₙ from nonvolatile memory 1 and applying these *n* product specification selecting signals 4₁-4ₙ to decoder 18 and decoding signals 4₁-4ₙ. This configuration allows the setting of product specifications in greater detail. Although CPU 2 acid internal bus 3 are not shown in Fig. 7, the semiconductor integrated circuit according to the third embodiment is also provided with CPU and internal bus similar to the semiconductor integrated circuit as shown in Fig. 2.

In the above-described embodiments, explanation was presented regarding examples in which the absence or presence of a pull-up resistance or oscillation ,stabilization time were taken as product specifications, but the items that can be set as product specifications in the present invention are not limited to these items. The present invention can be similarly applied in cases in which other product specifications are controlled by product specification signals that are outputted from the nonvolatile memory.

In addition to the items described in the foregoing explanation, product specifications that can be taken as the object of settings in the present invention include, for example,peripheral circuit functions of a semiconductor integrated circuit such as the communication protocol used or the specifications of three-wire serial communication, the specifications of an 8-bit timer incorporated in the semiconductor integrated circuit, the attributes of each terminal, and the number of LSI terminals. The attributes of a terminal indicate if a specific external terminal (pin) of a semiconductor integrated circuit is used as an input terminal, an output terminal, or as a terminal for both input and output.

While preferred embodiments of the present invention have been described using specific terms, such description is for illustrative purposes only, and it is to be understood that changes and variations may be made without departing from the scope of the following claims.

## Claims

1. A semiconductor integrated circuit that executes processing in accordance with a preset program, comprising a nonvolatile memory (1), said nonvolatile memory comprising:
a program region (11) that is programmable for storing said program;
a product specification setting region (12) that is programmable for storing product specification setting information for setting product specification; and
a selection circuit (141, 142) for selecting and putting into operation said program region (11) and said product specification setting region (12);
wherein, when selecting said product specification setting region (12) in said nonvolatile memory (1), said product specification setting information is directly outputted from said nonvolatile memory (1) as a product specification signal,
**characterised in that**
the product specification is stored in the same memory region (1) as where the program is stored, so that the product specification can be changed.

2. A semiconductor integrated circuit according to claim 1, further comprising a decoder (8) for decoding said product specification selecting signal and generating a product specification signal for controlling product specification.

3. A semiconductor integrated.circuit according to claim 1 or 2 wherein said nonvolatile memory (1) is constituted by an EEPROM or a flash ROM.

4. A semiconductor integrated circuit according to claim 3, further comprising a decoder (8) for decoding said product specification selecting signal and generating a product specification signal for controlling product specification.

5. A semiconductor integrated circuit according to claim 1, 2, 3 or 4 wherein said product specification is specification of presence or absence of a pull-up resistance that is connected to an external terminal of said semiconductor integrated circuit.

6. A circuit according to any one of claims 1 to 5 wherein said product specification is specification of setting of an oscillation stabilization time.

7. A circuit according to any one of claims 1 to 6 wherein said product specification is specification of functions of peripheral circuits.

8. A circuit according to any one of claims 1 to 7 wherein said product specification is specification of an attribute of an external terminal of said semiconductor integrated circuit.

9. A circuit according to any one of claims 1 to 8 wherein said product specification is specification of the number of external terminals of said semiconductor integrated circuit.

10. A method of setting product specification of a semiconductor integrated circuit, comprising the steps of:
storing, in a programmable nonvolatile memory within a semiconductor integrated circuit, programs for carrying out preset processing operations and product specification setting information for setting product specification;
enabling only said program region to be accessible in said nonvolatile memory when normal operations are being carried out; and
enabling said product specification setting region in said nonvolatile memory to be accessible and rewriting product specification setting information stored in said product specification setting region, when product specification of said semiconductor integrated circuit is being altered.

11. A method of setting product specification of a semiconductor integrated circuit according to claim 10 wherein said product specification is specification of presence or absence of a pull-up resistance connected to an external terminal of said semiconductor integrated circuit.

12. A method of setting product specification of a semiconductor integrated circuit according to claim 10 or 11 wherein said product specification is specification of setting of an oscillation stabilization time.

13. A method of setting product specification of a semiconductor integrated circuit according to claim 10, 11 or 12 wherein said product specification is specification of functions of peripheral circuits.

14. A method according to any one of claims 10 to 13 wherein said product specification is specification of attribute of an external terminal of said semiconductor integrated circuit.

15. A method according to any one of claims 10 to 14 wherein said product specification is specification of the number of external terminals of said semiconductor integrated circuit.

## Patentansprüche

1. Integrierter Halbleiterschaltkreis, der eine Verarbeitung entsprechend einem voreingestellten Programm ausführt, mit einem nichtflüchtigen Speicher (1), wobei der nichtflüchtige Speicher aufweist:
einen Programmbereich (11), der zum Speichern des Programms programmierbar ist;
einen Produktspezifikationseinstellbereich (12), der zum Speichern von Produktspezifikationseinstellinformationen zum Einstellen der Produktspezifikation programmierbar ist; und
eine Wählschaltung (141,142) zur Auswahl und Inbetriebnahme des Programmbereichs (11) und des Produktspezifikationseinstellbereichs (12);
wobei bei der Auswahl des Produktspezifikationseinstellbereichs (12) in dem nichtflüchtigen Speicher (1) die Produktspezifikationseinstellinformation direkt aus dem nichtflüchtigen Speicher (1) als Produktspezifikationswählsignal ausgegeben wird,
**dadurch gekennzeichnet, daß** die Produktspezifikation im gleichen Speicherbereich (1) gespeichert wird, in dem das Programm gespeichert ist, so daß die Produktspezifikation geändert werden kann.

2. Integrierter Halbleiterschaltkreis nach Anspruch 1, der ferner einen Decodierer (8) zum Decodieren des Produktspezifikationswählsignals und zum Erzeugen eines Produktspezifikationssignals für die Steuerung der Produktspezifikation aufweist.

3. Integrierter Halbleiterschaltkreis nach Anspruch 1 oder Anspruch 2, wobei der nichtflüchtige Speicher (1) durch einen EEPROM oder Flash-ROM gebildet wird.

4. Integrierter Halbleiterschaltkreis nach Anspruch 3, der ferner einen Decodierer (8) zum Decodieren des Produktspezifikationswählsignals und zum Erzeugen eines Produktspezifikationssignals zur Steuerung der Produktspezifikation aufweist.

5. Integrierter Halbleiterschaltkreis nach Anspruch 1, 2, 3 oder 4, wobei die Produktspezifikation eine Spezifikation des Vorhandenseins oder Fehlens eines Pull-up-Widerstands ist, der mit einem äußeren Anschluß des integrierten Halbleiterschaltkreises verbunden ist.

6. Schaltkreis nach einem der Ansprüche 1 bis 5, wobei die Produktspezifikation eine Spezifikation der Einstellung einer Schwingungsstabilisierungszeit ist.

7. Schaltkreis nach einem der Ansprüche 1 bis 6, wobei die Produktspezifikation eine Spezifikation von Funktionen von Peripherieschaltungen ist.

8. Schaltkreis nach einem der Ansprüche 1 bis 7, wobei die Produktspezifikation die Spezifikation eines Attributs eines externen Anschlusses des integrierten Halbleiterschaltkreises ist.

9. Schaltkreis nach einem der Ansprüche 1 bis 8, wobei die Produktspezifikation eine Spezifikation der Anzahl externer Anschlüsse des integrierten Halbleiterschaltkreises ist.

10. Verfahren zum Einstellen der Produktspezifikation eines integrierten Halbleiterschaltkreises, mit den folgenden Schritten:
Speichern von Programmen zur Ausführung voreingestellter Verarbeitungsoperationen und von Produktspezifikationseinstellinformationen zum Einstellen der Produktspezifikation in einem programmierbaren nichtflüchtigen Speicher innerhalb eines integrierten Halbleiterschaltkreises;
Zugriffsfreigabe nur zu dem Programmbereich in dem nichtflüchtigen Speicher, wenn normale Operationen auszuführen sind; und
Zugriffsfreigabe zum Produktspezifikationseinstellbereich in dem nichtflüchtigen Speicher und Wiedereinschreiben von Produktspezifikationseinstellinformationen, die in dem Produktspezifikationseinstellbereich gespeichert sind, wenn die Produktspezifikation des integrierten Halbleiterschaltkreises geändert wird.

11. Verfahren zum Einstellen einer Produktspezifikation eines integrierten Halbleiterschaltkreises nach Anspruch 10, wobei die Produktspezifikation eine Spezifikation des Vorhandenseins oder Fehlens eines Pull-up-Widerstands ist, der mit einem externen Anschluß des integrierten Halbleiterschaltkreises verbunden ist.

12. Verfahren zum Einstellen einer Produktspezifikation eines integrierten Halbleiterschaltkreises nach Anspruch 10 oder 11, wobei die Produktspezifikation die Spezifikation der Einstellung einer Schwingungsstabilisierungszeit ist.

13. Verfahren zum Einstellen der Produktspezifikation eines integrierten Halbleiterschaltkreises nach Anspruch 10, 11 oder 12, wobei die Produktspezifikation die Spezifikation der Funktionen von Peripherieschaltungen ist.

14. Verfahren nach einem der Ansprüche 10 bis 13, wobei die Produktspezifikation die Spezifikation eines Attributes eines externen Anschlusses des integrierten Halbleiterschaltkreises ist.

15. Verfahren nach einem der Ansprüche 10 bis 14, wobei die Produktspezifikation die Spezifikationder Anzahl externer Anschlüsse des integrierten Halbleiterschaltkreises ist.

## Revendications

1. Circuit intégré à semi-conducteur, qui exécute un traitement en fonction d'un programme fixé au préalable, comprenant une mémoire non volatile (1), ladite mémoire non volatile comportant :
une zone de programme (11) qui peut être programmée pour mémoriser ledit programme ;
une zone de fixation de spécification de produit (12) qui peut être programmée pour mémoriser des informations de fixation de spécification de produit pour fixer la spécification de produit; et
un circuit de sélection (141, 142) destiné à sélectionner et à mettre en oeuvre ladite zone de programme (11) et ladite zone de fixation de spécification de produit (12) ;
dans lequel, lors de la sélection de ladite zone de fixation de spécification de produit (12) dans ladite zone de mémoire non volatile (1), lesdites informations de fixation de spécification de produit sont directement délivrées par ladite mémoire non volatile (1) en tant que signal de sélection de spécification de produit,
**caractérisé en ce que**
la spécification de produit est mémorisée dans la même zone de mémoire (1) que là où le programme est mémorisé, de sorte que la spécification de produit peut être modifiée.

2. Circuit intégré à semi-conducteur selon la revendication 1, comprenant, en outre, un décodeur (8) destiné à décoder ledit signal de sélection de spécification de produit et à générer un signal de spécification de produit pour commander la spécification de produit.

3. Circuit intégré à semi-conducteur selon la revendication 1 ou 2, dans lequel ladite mémoire non volatile (1) est constituée par une mêmoire EEPROM ou une mémoire ROM flash.

4. Circuit intégré à semi-conducteur selon la revendication 3, comprenant, en outre, un décodeur (8) destiné à décoder ledit signal de sélection de spécification de produit et à générer un signal de spécification de produit pour commander la spécification de produit.

5. Circuit. intégré à semi-conducteur selon la revendication 1, 2, 3 ou 4, dans lequel ladite spécification de produit est la spécification de la présence ou de l'absence d'une résistance d'arrêt qui est connectée à une borne externe dudit circuit intégré à semi-conducteur.

6. Circuit selon l'une quelconque des revendications 1 à 5, dans lequel ladite spécification de produit est la spécification de la fixation d'une durée de stabilisation des oscillations.

7. Circuit selon l'une quelconque des revendications 1 à 6, dans lequel ladite spécification de produit est la spécification des fonctions des circuits périphériques.

8. Circuit selon l'une quelconque des revendications 1 à 7, dans lequel ladite spécification de produit est la spécification d'un attribut d'une borne externe dudit circuit intégré à semi-conducteur.

9. Circuit selon l'une quelconque des revendications 1 à 8, dans lequel ladite spécification de produit est la spécification du nombre de bornes externes dudit circuit intégré à semi-conducteur.

10. Procédé pour fixer la spécification de produit d'un circuit intégré à semi-conducteur, comprenant les étapes consistant :
à mémoriser, dans une mémoire non volatile pouvant être programmée au sein d'un circuit intégré à semi-conducteur, des programmes destinés à mettre en oeuvre des opérations de traitement fixées au préalable, et des informations de fixation de spécification de produit pour fixer une spécification de produit ;
à permettre à ladite zone de programme uniquement d'être accessible dans ladite mémoire non volatile lorsque des opérations normales sont mises en oeuvre ; et
à permettre à ladite zone de fixation de spécification de produit dans ladite mémoire non volatile d'être accessible, et à réécrire les informations de fixation de spécification de produit mémorisées dans ladite zone de fixation de spécification de produit lorsque la spécification de produit dudit circuit intégré à semi-conducteur est modifiée.

11. Procédé pour fixer la spécification de produit d'un circuit intégré à semi-conducteur selon la revendication 10, dans lequel ladite spécification de produit est la spécification de la présence ou de l'absence d'une résistance d'arrêt qui est connectée à une borne externe dudit circuit intégré à semi-conducteur.

12. Procédé pour fixer la spécification de produit d'un circuit intégré à semi-conducteur selon la revendication 10 ou 11, dans lequel ladite spécification de produit est la spécification de la fixation d'une durée de stabilisation des oscillations.

13. Procédé pour fixer la spécification de produit d'un circuit intégré à semi-conducteur selon la revendication 10, 11 ou 12, dans lequel ladite spécification de produit est la spécification des fonctions des circuits périphériques.

14. Procédé selon l'une quelconque des revendications 10 à 13, dans lequel ladite spécification de produit est la spécification d'un attribut d'une borne externe dudit circuit intégré à semi-conducteur.

15. Procédé selon l'une quelconque des revendications 10 à 14, dans lequel ladite spécification de produit est la spécification du nombre de bornes externes dudit circuit intégré à semi-conducteur.
